# EUROPEAN PATENT APPLICATION

(11) **EP 1 004 937 A2**
(43) Date of publication of application: **31.05.2000**
(21) Application number: 99306101.9
(22) Date of filing: 30.07.1999
(51) Int. Cl.: G03F 7/20

(54) **Exposure apparatus and optical system therefor**

(30) Priority: 27.11.1998 JP 33759198
(71) Applicant: NIKON CORPORATION, Tokyo (JP)
(72) Inventor: Ozawa, Haruo, c/o Nikon Corporation, Chiyoda-ku, Tokyo (JP); Murayama, Masayuki, c/o Nikon Corporation, Chiyoda-ku, Tokyo (JP)
(74) Representative: Rackham, Stephen Neil

(57) **Abstract**

An exposure apparatus including an optical system for exposure apparatus (an illumination optical system) for applying light of a specific wavelength to a mask (12) formed with a pattern, and a projection optical system (13) for projecting a pattern image of the illuminated mask onto a substrate (14).

In the optical system for exposure apparatus, a plurality of independent chambers 42a-42g are formed in a frame (41), and, in each of the chambers, lids (44a-44g), piping (L1a-L1h), piping (L2a-L2g), valves (45a-45g), (46a-46g) and valves (48a-48g) for opening and closing passages in response to the value detected by an oxygen density sensors (47a-47g) are provided. Further, seven group of optical parts, that is, beam shaping lens (2); a mirror 3; a beam expander lens 4; a mirror (5); a fly-eye lens 6; a set of a first relay lens (7), a reticle blind 8 and a second relay lens (9); a set of a mirror 10 and a main condenser lens (11), are contained within different chambers (42a-42g) of the frame (41). Therefore, it is possible to shorten a time period required for replacing gas in the frame and to facilitate the gas replacement operation.

## Description

The present invention relates to an optical system for exposure apparatus (for example, an illumination optical system for illuminating a mask with patterns by an exposure light) and an exposure apparatus that uses far ultraviolet light for pattern formation in the process of producing semiconductor devices (IC, CCD, etc.), liquid crystal display devices, thin-film magnetic heads, and so forth.

The demand for larger-scale integration of semiconductor devices has been increasing year by year, and the pattern rule (i.e., a line width of a pattern) of the required circuit patterns has been correspondingly decreasing. It is known that the line width that can be resolved by a projection optical system reduces in proportion to the wavelength. Therefore, in order to form a circuit pattern of smaller pattern rule by photo-lithography process, it is only necessary to shorten the wavelength of light used for exposure. At the present, an exposure apparatus in which a KrF excimer laser having a wavelength of 248 nm is used as a light source has already been developed. Further, a mercury lamp having a wavelength of about 220 nm or 184 nm, an ArF excimer laser having a wave length of 193 nm and the like have been noted as a short wavelength light source.

In conventional exposure apparatuses in which g-ray (having a wavelength of 436 nm), i-ray (having a wavelength of 365 nm), a KrF excimer laser or a mercury lamp emitting light having a wave length of about 250 nm is used as a light source, since the wavelengths of these light beams are not overlapped with an absorption spectrum zone of oxygen, there is no inconvenience such as reduction in light available rate caused when light is absorbed by oxygen molecules in a light path and/or generation of ozone due to light absorption of the oxygen molecules.

However, in the light source such as the ArF excimer laser, since light emitting spectrum is overlapped with the absorption spectrum zone of oxygen, the above-mentioned reduction in light available rate and/or generation of ozone due to light absorption of the oxygen molecules will occur. For example, if it is assumed that transmittance of the ArF excimer laser beam in the vacuum or in inert gas such as nitrogen or helium is 100%/m, in a free-run condition (natural light emitting condition). i.e., in an ArF wide range laser, the transmittance becomes about 90%/m, and, even when an ArF narrow band laser is used for reducing a spectrum width to avoid absorbing lines of oxygen, the transmittance is decreased to about 98%/m.

It is considered that the reduction in transmittance is caused by influences of absorption of light caused by the oxygen molecules as well as generation of ozone. The generation of ozone not only affects a bad influence upon the transmittance (light available rate) but also worsens performance of the apparatus due to reaction to a surface of optical material or other components of parts.

In such exposure apparatuses, in order to prevent the reduction in transmittance and/or generation of ozone by reducing oxygen density in the light path, it is well known that a space including the entire light path must be filled with inert gas such as nitrogen (for example, refer to Japanese Patent Laid-open No. 6-260385 corresponding to U.S. P. No. 5,559,584).

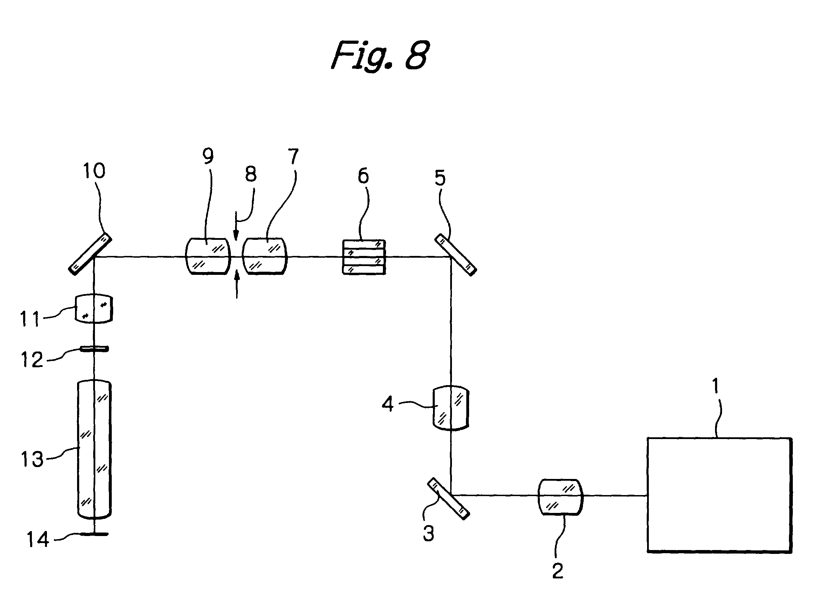

Fig. 8 schematically shows a construction of an exposure apparatus (optical systems associated with illumination and image focusing are mainly illustrated and other parts are omitted from illustration). A light beam from an ArF excimer laser light source 1 is changed to a predetermined form by a beam shaping lens 2 and then is reflected by a mirror 3 to be incident on a beam expander lens 4. The light flux incident to the beam expander lens 4 is expanded or enlarged to a predetermined magnitude and then is reflected by a mirror 5 to be directed to a fly-eye lens 6 as an optical integrator, where illuminance is made uniform and an illuminating range is determined. Light from the fly-eye lens 6 is focused on a reticle conjugate surface by a first relay lens 7. The reticle conjugate surface is provided with a reticle blind 8 for regulating or limiting an exposure range. Light passed through the reticle blind 8 is illuminated onto a reticle 12 through a second relay lens 9, a mirror 10 and a main condenser lens 11. Light having passed through the reticle 12 is illuminated onto a wafer 14 through a projection lens 13, thereby focusing an image of the reticle 12 on the wafer 14.

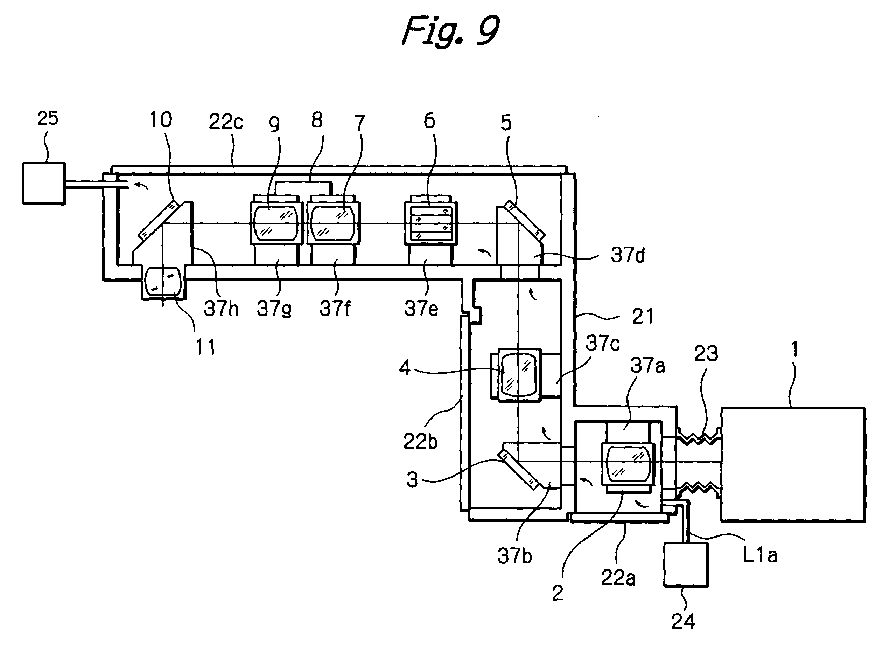

Fig. 9 is a sectional view of an illumination optical system of the exposure apparatus, showing a light path from the ArF excimer laser light source 1 to the main condenser lens 11. A frame 21 contains optical parts such as the beam shaping lens 2 constituting the illumination optical system and is attached to the ArF excimer laser light source 1 via a bellows 23. Nitrogen gas from a nitrogen gas supply source 24 is supplied from one side of the frame 21 (i.e., a side to which the laser light source 1 is attached in Fig. 9) through a piping L1a and is discharged to a discharge device 25 from the other side of the frame 21.

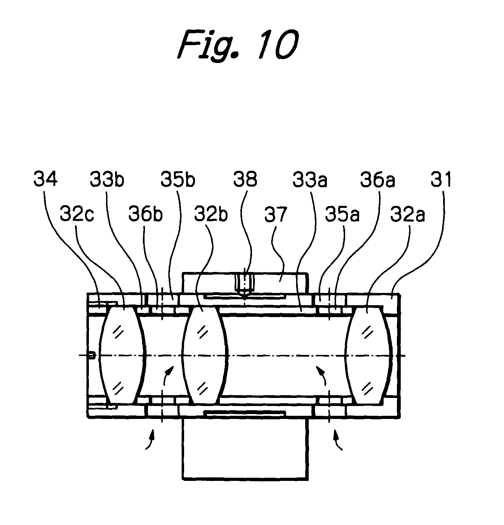

In Fig. 9, while various optical parts were shown with simplification, actually, as shown in Fig. 10 (fully described later), each of the optical parts is constituted by a plurality of lenses which are integrally secured to the frame 21 by a support blocks 37. In Fig. 9, the reflection mirror 10 and the main condenser lens 11 are secured to the frame 21 by using a same support block 37h, and the other optical parts are secured to respective support blocks 37a-37g.

Each of the optical parts secured to the frame 21 forms respective optical block at each of the support blocks 37a-37h, and maintenance (such as replacement) is effected for independent block. Lids 22a, 22b, 22c serves to close openings (through which the optical blocks are inserted and removed when the optical blocks are mounted and dismounted with respect to the frame 21) formed in the frame 21, so that the interior of the frame 21 is sealed by the lids 22a, 22b, 22c. Incidentally, although not shown, O-rings or packings are disposed between the frame 21 and the lids 22a, 22b, 22c to improve sealing ability.

Fig. 10 shows an example of the optical parts. Lenses 32a, 32b, 32c are successively inserted into a lens barrel 31 and are secured by a hold-down ring 34. Incidentally, there are provided separation rings 33a, 33b for maintaining predetermined distances between the lenses. Vent holes 35a, 35b, 36a, 36b formed in the lens barrel 31 and the separation rings 33a, 33b serve to introduce inert gas between the lenses. When the nitrogen gas is supplied into the frame 21, the nitrogen gas also flows into the lens barrel 31 through the vent holes 35a, 35b, 36a, 36b to replace the air between the lenses by the nitrogen gas. The lens barrel 31 is secured to the support block by set screws 38.

However, in the illumination optical system of the exposure apparatus shown in Fig. 9, even when maintenance regarding at least one of the parts disposed in the frame 21 is effected, the entire interior of the frame 21 is exposed to atmosphere. Thus, a large amount of nitrogen gas contained within the frame 21 escapes or leaks outside, with the result that it takes a long time to re-fill the nitrogen gas in the frame 21 after the maintenance. Further, it is very difficult to judge whether the frame 21 is filled with the nitrogen gas sufficient to not affect an influence upon the exposure.

An object of the present invention is to provide an exposure apparatus and an optical system for such an exposure apparatus, in which a time period required for replacing air by inert gas in a frame during the maintenance can be reduced and the replacing operation can easily be performed.

According to a first aspect of this invention an optical system has a plurality of optical parts contained in a frame , and the frame is divided into a plurality of chambers and the plurality of optical parts are housed in the different chambers of the frame , and gas replacing means for replacing gases in the respective chambers are provided.

According to a second aspect of this invention, the optical system is applied to an exposure apparatus in which a plurality of optical parts are contained in a frame and the frame is provided with a plurality of chambers interconnected through connection passages and the plurality of optical parts are housed in the different chambers of the frame and there are provided a gas supply means for supplying inert gas to a first chamber disposed at one end of the group of the interconnected chambers and a discharge passage L1h for discharging gas from a second chamber disposed at the other end of the group of the interconnected chambers and lids and valves for blocking the communication between the adjacent chambers through the connection passages when the lids are opened and for permitting the communication between the adjacent chambers through the connection passages when the lids are closed are provided in association with at least one of the chambers.

According to a third aspect of this invention, there are provided oxygen density sensors for detecting density of oxygen in chambers having lids and discharge switching means for permitting discharge of gas into the adjacent chambers through the connection passages at the second chamber side when the oxygen density detected by the oxygen density sensors is less than a predetermined value and for discharging the gas in the chambers out of the frame when the oxygen density is greater than the predetermined value.

According to a fourth aspect of the invention an exposure apparatus is provided with a flow rate sensor for detecting a flow rate of gas discharged from a discharge passage and a control device for controlling to turn OFF a light source of the exposure apparatus when the flow amount detected by the flow rate sensor is less than a predetermined value.

According to a fifth aspect of the invention the optical system according to the above first aspect is applied to an exposure apparatus in which a plurality of optical parts are contained in a frame and the frame is divided into a plurality of chambers and the plurality of optical parts are housed in the different chambers of the frame and gas supply means for supplying inert gas to the chambers and gas discharging means for discharging the gases in each of the chambers to an outside thereof are provided. Further, at least one of said plurality of chambers comprises lids for opening and closing said chambers, a discharge passage for discharging the gases in the chambers valves for blocking supply of inert gas from the gas supply means when the lids are opened and for permitting the supply of inert gas from the gas supply means when the lids are closed, oxygen density sensors for detecting oxygen density in the chambers and discharge switching means for permitting discharge of gas from the discharge passage when the oxygen density detected by the oxygen density sensors is less than a predetermined value and for discharging the gas from the frame when the oxygen density is greater than the predetermined value.

According to a sixth aspect of the invention an exposure apparatus has an optical system according to any one of the above-mentioned first to fifth aspects.

According to a seventh aspect of this invention, an exposure apparatus comprises a light source emitting exposure light to said optical system is connected any one of said plurality of chambers; and further comprises a partition member disposed on a light path of the exposure light and adapted to isolate a space in the chamber to which said light source is connected from another space on a side of said light source and permitting transit of the exposure light from said light source.

According to an eight aspect of this invention an exposure apparatus comprises a light source emitting exposure light; a frame having an optical system on which the exposure light is incident and having an inner space filled with specific gas; a light source unit connected to said frame and containing said light source and a partition member provided on a light path of the exposure light and adapted to isolate a space within said frame from another space within said light source unit and permitting transit of the exposure light of said light source.

According to a ninth aspect of this invention, an exposure apparatus is provided wherein said partition member forms a part of a transmission optical system which directs the exposure light from said light source to said optical system, and a face of said partition member is inclined with respect to a plane perpendicular to an optical axis of said transmission optical system.

Particular embodiments of the present invention will now be described with reference to the accompanying drawings in which:
Fig. 1 is a sectional view of an illumination optical system, which is a part of an embodiment of an exposure apparatus according to the present invention;
Fig. 2 is a view for explaining replacement of gas during assembling of the illumination optical system, where Fig. 2A shows a condition after completion of attachment of optical parts, Fig. 2B shows replacement of gas in a chamber 42a, and Fig. 2C shows replacement of gas in a chamber 42b;
Fig. 3 is a view for explaining replacement of gas during maintenance, where Fig. 3A shows a condition that a lid 44f of a chamber 42f is opened, and Fig. 3B shows replacement of gas in the chamber 42f after the lid 44f is closed;
Fig. 4 is a view for explaining an alteration;
Fig. 5 is a view for explaining replacement of gas during maintenance of an apparatus of Fig. 4, where Fig. 5A shows a condition that a lid 44f of a chamber 42f is opened, and Fig. 5B shows replacement of gas in the chamber 42f after the lid 44f is closed;
Fig. 6 is a view showing another embodiment of an exposure apparatus;
Fig. 7 is a view for explaining a case where a window member 54 is inclined;
Fig. 8 is a schematic view showing an exposure apparatus;
Fig. 9 is a sectional view of an illumination optical system of the exposure apparatus of Fig. 8; and
Fig. 10 is a view showing an example of optical parts;

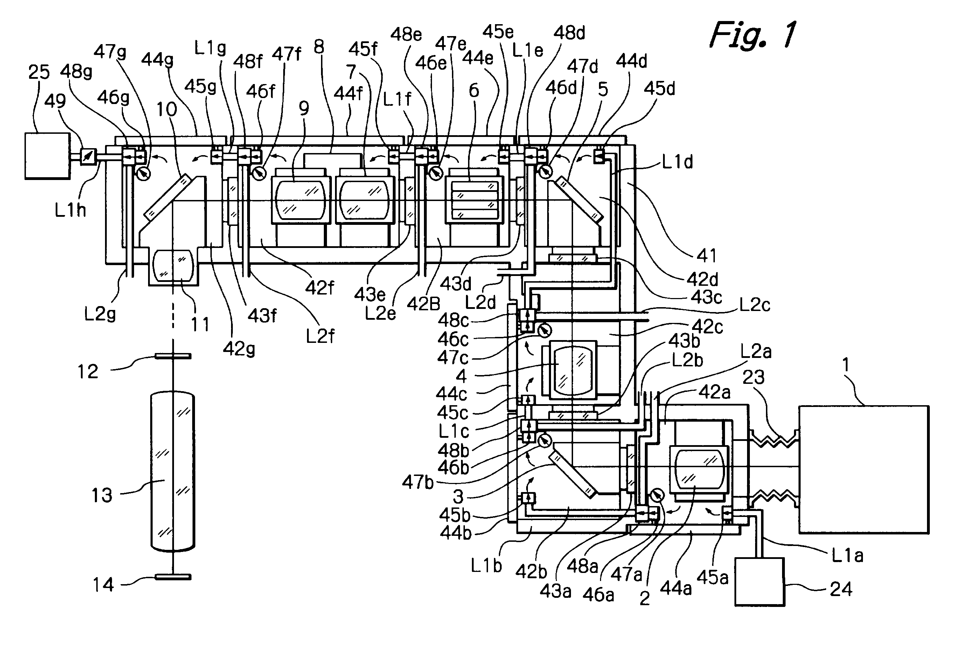

An embodiment of the present invention will be explained with reference to Figs. 1 to 5. Fig. 1 is a detailed sectional view of an illumination optical system, which is a part of the embodiment of an exposure apparatus according to the present invention. Incidentally, since optical parts constituting the illumination optical system are the same as those of the exposure apparatus shown in Fig. 9, the same elements as those in Fig. 9 are designated by the same reference numerals. Similarly, the reference numerals 12, 13 and 14 denote a reticle, a projection lens and a wafer, respectively, as is similar to Fig. 8. The optical parts are attached within a frame 41 every optical block. The frame 41 are divided into seven chambers 42a-42g, and windows 43a-43f including optical parts are disposed in light path portions formed in partitions between the chambers. Incidentally, when the illumination optical system is designed, features of the windows 43a-43f are taken into consideration. Lids 44a-44g for closing and sealing openings of the chambers are detachably attached to the chambers 42a-42g. Incidentally, although not shown, o-rings or packing are disposed between the frame 41 and the lids 44a-44g to improve sealing ability.

Pipings L1a-L1g serve to supply nitrogen gas from a nitrogen gas supply source 24 to the chambers 42a-42g, and valves 45a-45g are provided in the pipings L1a-L1g. Pipings L2a-L22g serve to discharge the gas in the chambers 42a-42g out of the frame 41, and valves 48a-48g serve to switch or determine whether the gas in the chambers 42a-42g is directed to the adjacent chamber through the pipings L1a-L1g or is discharged out of the frame through the pipings L2a-L2g. Valves 46a-46g are disposed at inlets of the valves 48a-48g. Vent of the valves 48a-48g is switched on the basis of signals from oxygen density sensors 47a-47g for detecting oxygen density in the chambers 42a-42g. A flow rate sensor 49 is disposed in the piping L1h between the chamber 42g and a discharge device 25. The pipings L2a-L2g serve to discharge the gas out of a chamber (not shown) containing the body of the exposure apparatus. Each chamber may have the nitrogen gas supply source 24 and the discharge device 25.

The valves 45a-45g and 46a-46g are opened when the lids 44a-44g are closed and are closed when the lids 44a-44g are opened. A switch turned ON/OFF in synchronous with opening/closing of the lids 44a-44g may be provided to control the valves, or the valves may be controlled mechanically. Further, as an example, the switching of the valves 48a-48g are performed as follows. When the oxygen density detected by the oxygen density sensors 47a-47g is greater than a predetermined oxygen density value (for example, 1% sufficient to prevent absorption of exposure light and generation of ozone), the gas is directed to the pipings L2a-L2g to reduce the oxygen density, and, when the oxygen density is decreased below the predetermined value, the gas is directed to the pipings L1a-L1g. In Fig. 1, all of the lids 44a-44g are closed showing the fact that the oxygen density in the chambers 42a-42g are less than the predetermined value. Incidentally, the arrows show flow of nitrogen gas.

Now, operations of the above-mentioned valves and oxygen density sensors during the gas replacing operation in the chambers 42a-42g will be explained as the following two examples:
(a) gas replacement during assembling of the illumination optical system; and
(b) gas replacement during maintenance.

### (1) During the assembling of the illumination optical system:

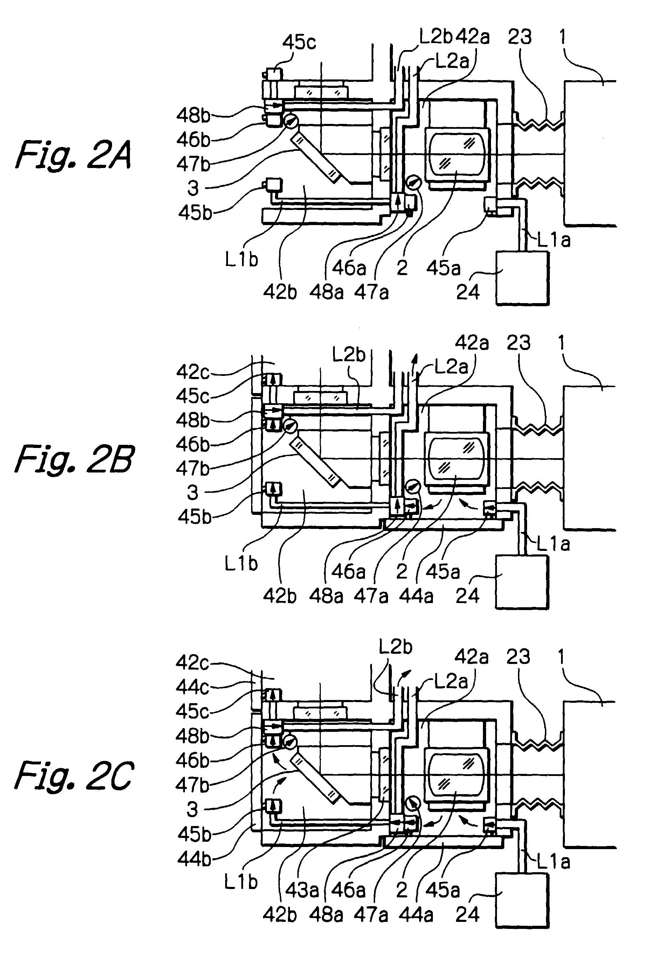

Fig. 2A is a sectional view of the chambers 42a and 42b shown in Fig. 1 and shows a condition after the attaching of the optical parts within the frame 41 is completed. In this condition, the lids 44a, 44b of the chambers 42a, 42b are opened. (In Fig. 2A, the lids 44a, 44b are omitted from illustration). In the condition that the lids 44a, 44b are opened, as mentioned above, the valves 45a, 45b, 46a, 46b are closed. Further, since the oxygen density detected by the oxygen density sensors 47a, 47b exceeds the predetermined value, the vale 48a communicates with the piping L2a and the valve 48b communicates with the piping L2b. In Fig. 2A - 2C, the arrows on the valves 45a-45c, 46a, 46b show valve open conditions, and the arrows on the valves 48a, 48b show communication directions of the valves 48a, 48b. The other arrows show flow of the nitrogen gas. Further, the arrows on the oxygen density sensors 47a, 47b show whether the detected oxygen density is higher than the predetermined value or not, and, when higher than the predetermined value, the arrow directs toward a right and upper direction, and, when lower than the predetermined value, the arrow directs toward a left and upper direction. Then, when the lids 44a-44g of all of the chambers 42a-42g are closed, the valves 45a-45g, 46a-46g are opened, with the result that, as shown in Fig. 2B, the nitrogen gas is supplied to the chamber 42a through the piping L101a. In this case, since the valve 48a is communicated with the piping L2a until the oxygen density in the chamber 42a reaches the predetermined value, the nitrogen gas is supplied to the chamber 42a and the air in the chamber 42a is discharged out of the frame 41 through the piping L2a. As a result, the air in the chamber 42a is gradually replaced by the nitrogen gas, thereby decreasing the oxygen density accordingly.

Thereafter, when the oxygen density in the chamber 42a is decreased below the predetermined value, as shown in Fig. 2C, the communication direction of the valve 48 is changed from the piping L2a to the piping L1b, thereby supplying the nitrogen gas to the chamber 42b. As is similar to the chamber 42a, the gas in the chamber 42b is discharged out of the frame 41 through the piping L2b until the oxygen density is decreased below the predetermined value. When the oxygen density is decreased below the predetermined value, the communication direction of the valve 48b is changed from the piping L2b to the piping L1c, thereby supplying the nitrogen gas to the chamber 42c. Similarly, the air in the chambers 42c-42g shown in Fig. 1 are successively replaced by nitrogen gases.

When the oxygen density in the chamber 42g is greater than the predetermined value, since the valve 48g is communicated with the piping L2g, the flow rate sensor 49 (Fig. 1) does not detect the gas flow. To the contrary, when the oxygen density in the chamber 42g becomes less than the predetermined value, since the communication direction of the valve 48g is changed from the piping L2g to the piping L1h, the gas in the chamber 42g flows into the discharge device 25 and is detected by the flow rate sensor 49. Thus, by utilizing the output of the flow rate sensor 49, the fact that the replacement of gas after assembling can be ascertained.

### (2) During the maintenance:

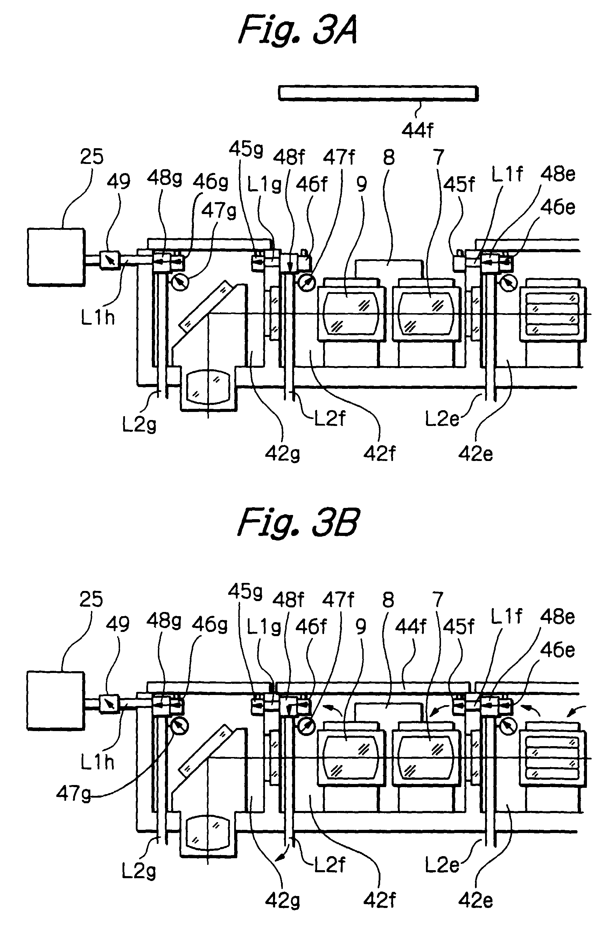

Next, during the maintenance, for example, the maintenance of a motor for driving the reticle blind 8 will be explained with reference to Fig. 3. Incidentally, in Fig. 3, the chamber 42f and adjacent chambers are shown, and other chambers are omitted from illustration. First of all, as shown in Fig. 3A, when the lid 44f of the chamber 42f in which the reticle blind 8 is secured is opened, the valves 45f, 46f are closed. In this case, since the chamber 42f is communicated with the atmosphere, the oxygen density becomes greater than the predetermined value, with the result that the valve 48f is communicated with the piping L2f. Consequently, the communication between the chambers 42f and 42e and the communication between the chambers 42f and 42g are blocked, with the result that the chambers other than the chamber 42f remain to be filled with the nitrogen gas. However, since the gas in the chamber 42g is discharged by the discharge device 25, the pressure in the chamber 42g is held to a value less than the atmospheric pressure. Thus, until the pressure in the chamber 42g becomes substantially constant, the flow rate detected by the flow rate sensor 49 is very small, and, after the pressure becomes substantially constant, the flow rate sensor 49 does not detect the flow rate. Incidentally, the arrow on the flow rate sensor 49 indicates the magnitude of the flow rate. Particularly, in the condition shown in Fig. 1, the arrow direction toward a right and upper direction indicates the fact that the gas is flowing in a steady-state condition, and, as shown in Fig. 3, when the chamber 42f is subjected to maintenance and the gas is almost not flowing, such a condition is indicated by the arrow directing toward a left and upper direction.

After the maintenance is finished, when the lid 44f is closed as shown in Fig. 3B, the valves 45f, 46f are opened, with the result that the nitrogen gas flows from the chamber 42e to the chamber 42f. However, immediately after the lid 44f is closed, since the oxygen density in the chamber 42f is greater than the predetermined value, the valve 48f remains to be communicated with the piping L2f, with the result that the gas in the chamber 42f is discharged out of the frame 41 through the piping L2f. Thereafter, when the oxygen density in the chamber 42f becomes less than the predetermined value, the communication direction of the valve 48f is changed to the piping L1g, with the result that the nitrogen gas in the chamber 42f flows into the chamber 42g and is discharged by the discharge device 25.

When the nitrogen gas is discharged by the discharge device 25, since the gas flow is detected by the flow rate sensor 49, by utilizing the output of the flow rate sensor 49, the fact that the maintenance is finished can be recognized. Further, when the output is used for interlock of the ArF excimer laser light source 1, if the replacement of nitrogen is insufficient during the maintenance or after the maintenance, a control circuit of the exposure apparatus can control to stop the emission of the laser beam. Further, even when supply from a nitrogen gas supply source 24 is stopped or the flow rate is decreased, such a condition can be detected, and, in such a condition, the emission of the laser beam may be stopped.

The above-mentioned embodiment gives the following advantages.
(1) Since the frame 41 of the illumination system is divided into the chambers at every optical block, during the maintenance, only the chamber of the optical block requiring the maintenance may be communicated with the atmosphere, with the result that leakage of gas during the maintenance can be reduced and the time period required for replacement of nitrogen gas after the maintenance can be shortened.
(2) By providing the valves 45a-45g, 46a-46g opened and closed in synchronous with the closing/opening of the lids 44a-44g and the valves 48a-48g for switching the communication direction, depending on the oxygen density in the chambers 42a-42g, ① supply and stop of the nitrogen gas into the chambers 42a-42g and ② the replacement of gas in the chambers 42a-42g can automatically be effected, depending on the opening/closing of the lids 44a-44g. Thus, the maintenance can be facilitated and the time period required for the maintenance can be shortened.
(3) By monitoring the flow rate of discharged gas by using the flow rate sensor 49, the completion of the maintenance can automatically be judged and the output of the sensor can be used in the interlock of the ArF excimer laser light source 1. Thus, erroneous laser illumination before replacement of nitrogen gas can be prevented.

In place of the signal of the flow rate sensor 49, signals from the oxygen density sensors 47a-47g may be used for the aforementioned interlock. That is to say, if any one of the oxygen density sensors 47a-47g detects the oxygen density greater than the predetermined value, it is judged as under maintenance, and, if all of the sensors detect the oxygen density less than the predetermined value, it is judged as completion of maintenance. However, in such a case, unlike to usage of the flow rate sensor 49, the change in flow rate of the nitrogen gas cannot be detected.

### (Alteration)

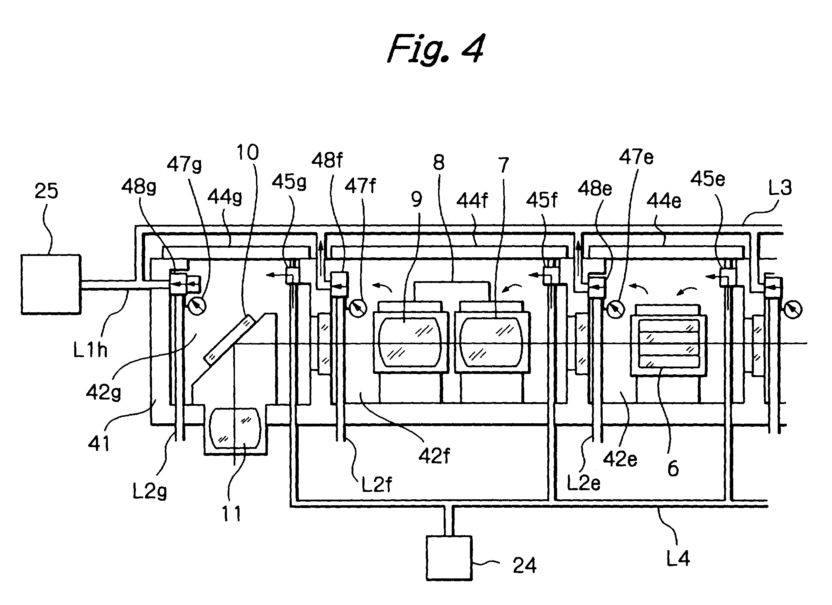

Fig. 4 shows an alteration of the apparatus shown in Fig. 1. In this alteration, supply of nitrogen gas into the chambers is effected in parallel. Incidentally, Fig. 4 only shows a part of the apparatus (parts associated with the chambers 42e, 42f, 42g), and the same elements as those in Fig. 1 are designated by the same reference numerals, and differences will be mainly described. Nitrogen gas is supplied from the nitrogen gas supply device 24 to the chambers 42e, 42f, 42g in which optical parts are disposed through a piping L4. On the other hand, the gas in the chambers 42e, 42f, 42g is discharged by the discharge device 25 through a piping L3. That is to say, in the apparatus according to the alteration, the chambers for which the lids 44e-44g are closed are always subjected to nitrogen gas purge.

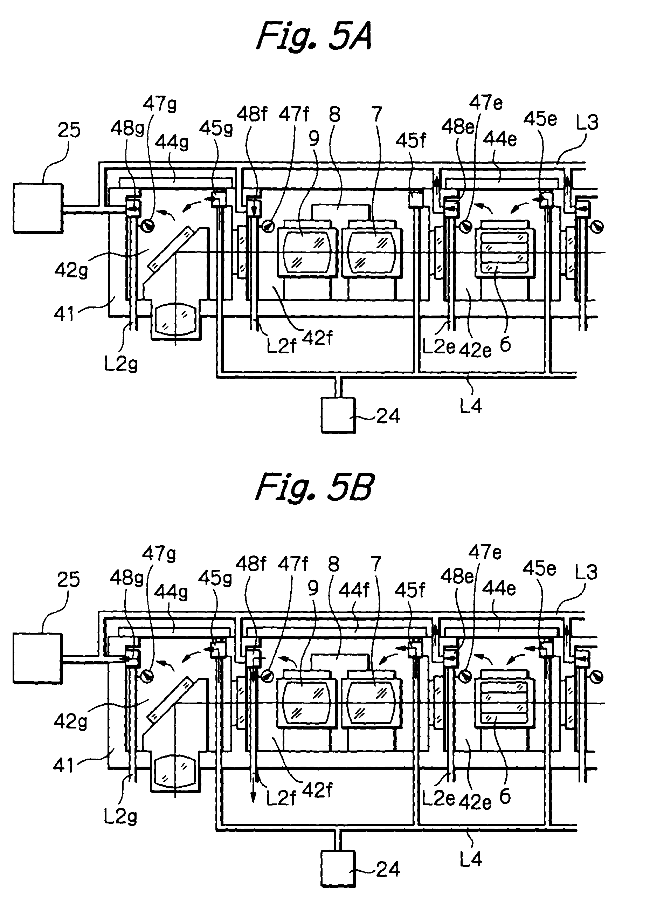

Next, Figs. 5A and 5B explain an operation of various valves when the maintenance of the reticle blind 8 is performed. As shown in Fig. 5A, when the lid 44f is opened to communicate the chamber 42f with the atmosphere, the valve 45f is opened and the oxygen density in the chamber 42f becomes greater than the predetermined value, with the result that the communication direction of the valve 48f is changed from the piping L3 to the piping L2f. In this case, the nitrogen gas purge of the other chambers 42e, 42g is still continued. After the maintenance is completed, when the lid 44f is closed as shown in Fig. 5B, the valve 45f is opened to supply the nitrogen gas into the chamber 42f. However, immediately after the lid 44f is closed, since the oxygen density in the chamber 42f is still greater than the predetermined value, the valve 48f is communicated with the piping L2f, with the result that the gas in the chamber 42f is discharged through the piping L2f.

Thereafter, as the replacement of gas in the chamber 42f continues, when the oxygen density becomes less than the predetermined value, the communication direction of the valve 48f is changed from the piping L2f to the piping L3, with the result that the gas in the chamber 42f is discharged by the discharge device 25. In the apparatus according to this alteration, the completion of the maintenance is judged on the basis of the signals from the oxygen density sensors 47e-47g. That is to say, if one of the oxygen density sensors 47a-47g detects the oxygen density greater than the predetermined value, it is judged as under maintenance, and, if all of the sensors detect the oxygen density less than the predetermined value, it is judged as completion of maintenance.

In the apparatus shown in Fig. 1, as shown in Fig. 3A, when the oxygen density in the chamber 42f is greater than the predetermined value to communicate the valve 48f with the piping L2f, the chamber 42g at a downstream side of the chamber 42f regarding gas purge may have pressure smaller than the atmospheric pressure as mentioned above. In consideration of this, it is required that the chambers are designed to resist against the external atmospheric pressure. However, in the apparatus according to the alteration, since the chambers having the closed lids are always subjected to the gas purge, great strength such as that in the apparatus of Fig. 1 is not required.

### (Another Embodiment)

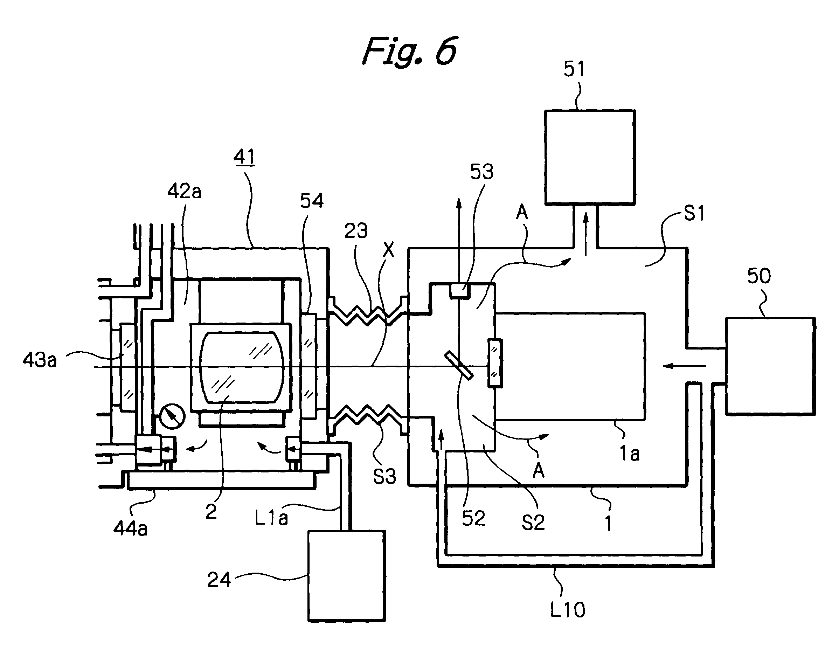

Fig. 6 shows another embodiment of an exposure apparatus according to the present invention and shows a chamber 42a at an ArF excimer laser light source side of an illumination optical system and the laser light source 1 in detail. In general, two spaces S1, S2 are formed in the laser light source 1, and a laser generating portion 1a is housed in the space S1. A gas supply device 50 and a discharge device 51 are connected to the space S1, and gas (generally, inert gas) supplied from the gas supply device 50 to the space S1 is circulated within the space S1 and is discharged by the discharge device 51. On the other hand, as shown in Fig. 6, the space S2 is communicated with a space S3 defined by a bellows 23, and gas is supplied to the space S2 from the gas supply source 50 through a piping L10. By detecting reflection light from a mirror 52 by means of a detector 53, intensity of the laser beam is detected.

In general, pressure in the space S1 is selected to be smaller than pressure in the space S2 and the atmospheric pressure. Thus, while flow of gas from the space S2 to the space S1 (as shown by an arrow A) may be generated and the air may flow into the space S1 from the atmosphere, the gas does not leak from the space S1 to the atmosphere. The reason why the laser light source 1 has the above-mentioned construction is that, even if ArF gas used in the laser generating portion 1a leaks, a room in which the exposure apparatus is installed is prevented from being contaminated by the ArF gas. For example, if the ArF gas leaks into the space S1, the ArF gas does not leak from the space S1 toward the atmosphere but is discharged by the discharge device 51. On the other hand, if the ArF gas leaks into the space S2, since the ArF gas flows from the space S2 into the space S1 and then is discharged by the discharge device 51, the ArF gas does not leak toward the atmosphere.

In the aforementioned embodiment, while an example that the chamber 42a in which the beam shaping lens 2 is housed is communicated with the bellows 23 was explained, in this embodiment, there is provided a window 54 (made of quartz or fluorite) as a partition between the chamber 42a and the space S3 defined by the bellows 23. With this arrangement, the space S2 of the laser light source 1 is isolated from the chamber 42a by the window 54 to give the following advantages, in addition to the advantages of the aforementioned embodiment:
① The replacement gas in the frame 41 in which the optical parts are housed is prevented from flowing toward the laser light source 1. As mentioned above, since the pressure in the frame 41 is greater than the pressure in the space S1 of the laser light source 1, if there is no window 54 in Fig. 6, the gas flows from the frame 41 through the spaces S3, S2 to the space S1; however, in this embodiment, such gas flow can be prevented by the window 54. As a result, the replacement gas in the frame 41 does not flow into the replacement area (spaces S1 and S2) of the laser light source 1, thereby protecting the replacement area of the laser light source 1.
② During the maintenance of the beam shaping lens 2, when the chamber 42a is opened to the atmosphere, the space S2 of the laser light source 1 can be prevented from being exposed to the atmosphere.
③ Even if the ArF gas flows into the bellows 23 due to an accident, since the ArF gas does not flow from the bellows 23 into the frame 41, the optical parts within the frame can be protected.

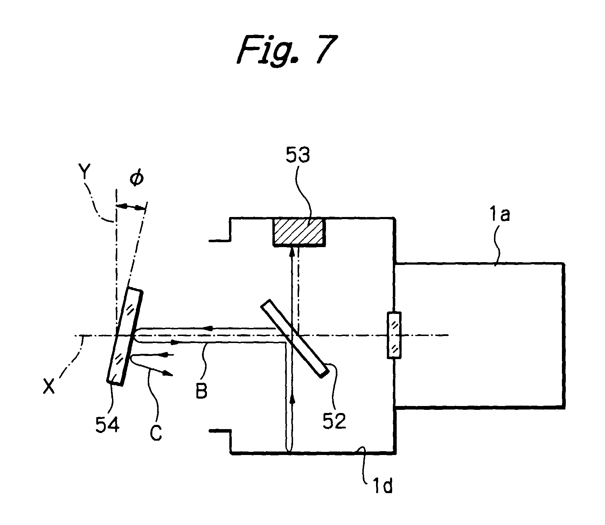

Fig. 7 shows an alteration of the apparatus of Fig. 6. In this alteration, a face of the window 54 is inclined by an angle of θ with respect to an axis Y perpendicular to an optical axis X. The other arrangements are the same as those of the apparatus shown in Fig. 6. In Fig. 7, "B" indicates a light path of a laser beam reflected by the window 54 if the face of the window 54 is arranged perpendicular to the optical axis X. The reflected laser beam B is reflected downwardly by a half mirror 52 and is reflected by an inner surface 1d of the laser light source 1 and then is passed through the half mirror 52 to be incident on a detector 53. Thus, this arrangement affects a bad influence upon the measurement of intensity of laser beam.

To the contrary, when the face of the window 54 is inclined by the angle of θ with respect to the axis Y in the apparatus in Fig. 7, since the laser beam is reflected rightwardly and downwardly (as a reflected beam C), the reflected beam does not enter into the detector 53, unlike to the reflected beam B. The angle θ is selected so that the reflected beam does not enter into the detector 53 and is preferably about 10 degrees. Incidentally, the window 54 may also act as an optical part of the illumination optical system. In the illustrated embodiment, while an example that the frame 41 is directly connected to the chamber 42a at the laser light source 1 side via the bellows 23 was explained, a transmission optical system may be disposed between the frame 41 and the chamber 42a at the laser light source 1 side.

The transmission optical system is constituted by optical elements such as a mirror, a prism and a lens disposed on an optical axis, and a cover for sealing these optical elements. In the illustrated embodiment, when such a transmission optical system is provided, one end of the cover of the transmission optical system may be connected to the chamber 42a at the laser light source 1 side, and the other end of the cover of the transmission optical system may be connected to the bellows 23.

Further, in the illustrated embodiment, while an example that the partition window 54 is disposed between the chamber 42a at the laser light source 1 side and the space S3 defined by the bellows 23 was explained, the partition window 54 may be disposed between the space S2 of the laser light source 1 and the space S3 defined by the bellows 23. Further, such windows 54 may be disposed between the chamber 42a of the frame 41 and the space S3 defined by the bellows 23, and between the space S2 of the laser light source 1 and the space S3 defined by the bellows 23.

The window 54 may be constituted by one of the optical elements of the transmission optical system. In addition, since the window 54 may be contaminated (or fogged) by illumination of exposure light, it is desirable that the window can be replaced.

In the illustrated embodiments, while an example that the nitrogen gas is used as gas purged in the frame 41 was explained, other inert gas such as helium, neon, argon, krypton, xenon, radon or the like may be used. Specifically, when a wave length of light is less than 190 nm, it is preferable that inert gas such as helium, neon, argon or krypton may be used. Furthermore, when the KrF excimer laser is used, chemically clean dry air (air from which substances for causing fog of lenses (for example, ammonium ions tending to float within a clean room) are removed) may be used as gas purged in the chambers.

Further, in the illustrated embodiments, the sentence "optical parts are housed in chambers" means to include "group of optical parts are disposed at boundaries between chambers". That is to say, in place of the windows provided in the light paths in the partitions between the chambers, the optical parts may be arranged.

Regarding a relation between the embodiments as mentioned above and elements in claims, sets of (valve 48a, passage L2a) - (valve 48g, passage L2g) correspond to a discharge switching means; the gas supply device 24, valves 48a-48g and pipings L2a-L2g corresponds to a gas replacing means; the piping L1h corresponds to a discharge passage in claim 2; the piping L3 corresponds to a discharge passage in claim 5; the gas supply device 24 and piping L1a correspond to a gas supply means in claim 2; the gas supply device 24 and piping L4 correspond to a gas supply means in claim 5; and, a set of a mirror 10 and a main condenser lens 11, a set of first relay lens 7, reticle blind 8 and a second relay lens 9, a beam shaping lens 2, a mirror 3, a beam expander lens 4, a mirror 5 and a fly-eye lens 6 constitute seven optical parts.

Further, in the illustrated embodiments, as the exposure illumination light, ultraviolet light having a wavelength of 100 nm or more (for example, far ultraviolet (DUV) light such as g-ray, i-ray or KrF excimer laser, or, vacuum ultraviolet (VUV) light such as ArF excimer laser or F₂ laser (having a wavelength of 157 nm)) may be used. In an exposure apparatus having the F₂ laser as a light source, as is similar to the aforementioned embodiments, a reflection /refraction optical system is used as a projection optical system, and refraction optical members (lens elements) used in the illumination optical system and the projection optical system are all made of fluorite, and the air in the F₂ laser light source, illumination optical system and the projection optical system is replaced by helium gas, and a space between the illumination optical system and the projection optical system as well as a space between the projection optical system and the wafer are filled with helium gas. Further, in the exposure apparatuses using the F₂ laser, a reticle made of fluorite, synthetic quartz obtained by doping fluorine, magnesium fluoride or crystal is used. Incidentally, the refraction members used in the projection optical system may be made of not only fluorite but also at least one of synthetic quartz obtained by doping fluorine and magnesium fluoride and crystal.

In place of the excimer laser, for example, a high harmonic wave of a solid laser such as YAG laser having oscillation spectrum including a wavelength of either of 48 nm, 193 nm or 157 nm may be used.

Further, an infrared area emitted from a DFB semi-conductor laser or a fiber laser, or a visible band single wavelength laser may be amplified by, for example, a fiber amplifier doped by erbium (or both erbium and ytterbium) and then be wavelength-converted into ultraviolet light by using a non-linear optical crystal to obtain a high harmonic wave which can be in turn used in place of the excimer laser.

For example, when the oscillation wavelength of the single wavelength laser is within a range of 1.51 µm - 1.59 µm, an eight-time high harmonic wave generating a wavelength of 189 - 199 nm or a ten-time high harmonic wave generating a wavelength of 151 - 159 nm is outputted. Particularly when the oscillation wavelength is within a range of 1.544 µm - 1.553 µm, an eight-time high harmonic wave generating a wavelength of 193 - 194 nm (i.e., ultraviolet light having a wavelength substantially the same as that of the ArF excimer laser) can be obtained. Further, when the oscillation wavelength is within a range of 1.57 µm - 1.58 µm, a ten-time high harmonic wave generating a wavelength of 157 - 158 nm (i.e., ultraviolet light having a wavelength substantially the same as that of the F₂ laser) can be obtained.

Further, when the oscillation wavelength is within a range of 1.03 µm - 1.12 µm, a seven-time high harmonic wave generating a wavelength of 147 - 160 nm is outputted, and, particularly when the oscillation wavelength is within a range of 1.099 µm - 1.106 µm, a seven-time high harmonic wave generating a wavelength of 157 - 158 nm (i.e., ultraviolet light having a wavelength substantially the same as that of the F₂ laser) can be obtained. Incidentally, an ytterbium dope fiber laser is used as the single wavelength oscillation laser.

Of course, in the above embodiment, the wavelength of the exposure illumination light is not limited to 100 nm or more. For example, in order to expose a pattern having a dimension of 70 nm or less, SOR or plasma laser is used as a light source to generate EUV (Extreme Ultra Violet) light having a soft X-ray area (for example, area having a wavelength of 5 - 15 nm), and EUV exposure apparatuses using an all reflection demagnification optical system and a reflection type mask which are designed on the basis of the exposure wavelength (for example, 13.5 nm) have been developed. In such apparatuses, since it is considered to provide an arrangement in which the mask and a wafer are simultaneously scanned by using an arc illumination, the present invention can also be applied to such apparatuses.

Regarding the projection optical system, not only a demagnification system but also an equal-magnification system or an enlargement (or magnification) system (for example, a liquid crystal display manufacturing exposure apparatus) may be used.

Further, the present invention can also be applied to not only the exposure apparatus used for manufacturing the semi-conductor element but also an exposure apparatus used for manufacturing a display including a liquid crystal display element and adapted to transfer a device pattern onto a glass plate, an exposure apparatus used for manufacturing a thin film magnetic head and adapted to transfer a device pattern onto a ceramic wafer and an exposure apparatus used for manufacturing an imaging element (such as CCD). Further, the present invention can also be applied to an exposure apparatus for transferring a circuit pattern onto a glass substrate or a silicon wafer in order to manufacture a reticle or a mask.

By incorporating the illumination optical system and the projection optical system which include a plurality of lenses into the exposure apparatus and by effecting optical adjustment and by attaching a reticle stage and a wafer stage which include a number of mechanical parts to the exposure apparatus and by effecting wiring and piping and further by effecting entire adjustment (electrical adjustment and check of performance), the exposure apparatus according to the illustrated embodiments can be manufactured. Incidentally, it is desirable that the exposure apparatus is manufactured in a clean room in which a temperature and cleanness are controlled.

The semi-conductor device is manufactured through a step for designing function and performance of the device, a step for manufacturing a reticle on the basis of the designing step, a step for manufacturing a wafer from silicon material, a step for exposing a pattern of the reticle onto the wafer by using the exposure apparatus according to the illustrated embodiment, a step for assembling the device (including dicing process, bonding process and packaging process), and a checking step. As mentioned above, the present invention is not limited to the above-mentioned embodiments, and, of course, various alterations and modifications can be effected without departing from the scope of the invention.

As mentioned above, according to the present invention, since the optical parts are housed in the independent chambers, for example, when the maintenance is performed, only the chamber requiring the maintenance may be opened to the atmosphere, thereby reducing the loss of the inert gas and reducing the rise-time of the maintenance.

According to a further aspect, since supply and stop of the inert gas with respect the chambers are automatically effected in synchronous with the opening/closing of the lids, the maintenance operation can be simplified.

In addition, the replacement of gas only in the chamber opened to the atmosphere by opening the lid can be effected automatically and securely.

Furthermore, since the light source of the exposure apparatus is turned OFF until the flow rate sensor detects the flow rate when the oxygen density in the chamber reaches the value less than the predetermined value after the lid of the chamber is closed, during the maintenance, if the replacement of gas in the chamber is insufficient, the light source is prevented from being turned ON erroneously.

Still further, since supply and stop of the inert gas with respect the chambers and replacement of gas are automatically effected in synchronous with the opening/closing of the lids, the maintenance operation can be simplified.

Also, since the air spaces of the chambers and the frame to which the light source is connected are isolated from the air space of the light source side by the window member, if the frame or the chamber is contaminated by the atmosphere, the influence of the contamination does not affect upon the light source side, and, if the light source gas leaks in the light source side, the influence of gas leakage does not affect upon the frame and the chambers side.

Further, by inclining the face of the window member with respect to the plane perpendicular to the optical axis, a bad influence of the light reflected by the window member can be prevented from affecting upon the light source (for example, a bad influence upon the light amount measurement of the light amount detector provided in association with the light source).

## Claims

1. An exposure optical system in which a plurality of optical parts are housed in a frame, wherein:
a plurality of chambers are formed in said frame, and said optical parts are housed in the different chambers of said frame, respectively, and a gas supply system connected to the chambers to supply gases in said chambers is provided.

2. An exposure optical system according to claim 1, wherein at least one chamber among said plurality of chambers includes:
a gas supply system (24, L1a) for supplying specific gas into the one of said chambers;
a discharge passage (L1h) for discharging gas from said chambers;
a lid for opening/closing said chamber, and;
a valve for blocking or stopping a supply of said specific gas when said lid is opened and for permitting such a supply of specific gas when said lid is closed.

3. An exposure optical system according to claim 2, further comprising:
an oxygen density sensor which detects oxygen density in said chamber having said lid; and
a discharge switching mechanism which permits gas discharge to the adjacent chamber through said connection passage on a side of said another chamber arranged at the other end when the oxygen density detected by said oxygen density sensor is less than a predetermined value and which discharges gas in said chamber having said lid out of said frame when the oxygen density is greater than the predetermined value.

4. An exposure apparatus using the exposure optical system according to claim 3, comprising:
a flow rate sensor which detects a flow rate of gas discharged from said discharge passage; and
a control device which effects control so that a light source of the exposure apparatus is turned OFF when the flow rate detected by said flow rate sensor is less than a predetermined value.

5. An exposure optical system according to claim 1, wherein at least one chamber among said plurality of chambers includes:
a lid which opens and closes said chamber;
a first and second discharge means which discharges gas from said chambers;
a valve which blocks supply of special gas from said gas supply means when said lid is opened and which permits supply of special gas from said gas supply system when said lid is closed;
an oxygen density sensor which detects oxygen density in said chamber; and
a switching mechanism which permits gas discharge from said first discharge means when the oxygen density detected by said oxygen density sensor is less than a predetermined value and which discharges the gas through said second discharge means when the oxygen density is greater than the predetermined value.

6. An exposure apparatus having the exposure optical apparatus according to claim 1.

7. An exposure apparatus according to claim 4, wherein:
a light source emitting exposure light to said optical system is connected any one of said plurality of chambers; and
further comprising:
a partition member disposed on a light path of the exposure light and adapted to isolate a space in the chamber to which said light source is connected from another space on a side of said light source and permitting transit of the exposure light from said light source.

8. An exposure apparatus comprising:
a light source emitting exposure light;
a frame having an optical system on which the exposure light is incident and having an inner space filled with specific gas;
a light source unit connected to said frame and containing said light source; and
a partition member provided on a light path of the exposure light and adapted to isolate a space within said frame from another space within said light source unit and permitting transit of the exposure light of said light source.

9. An exposure apparatus according to claim 8, wherein said partition member forms a part of a transmission optical system which directs the exposure light from said light source to said optical system, and a face of said partition member is inclined with respect to a plane perpendicular to an optical axis of said transmission optical system.

10. An exposure optical system comprising:
a frame containing a plurality of optical elements; and
a partition member disposed within said frame and adapted to dividing an interior of said frame into a plurality of spaces; and wherein
said optical elements are arranged within said chambers partitioned by said partition member.

11. An exposure optical system according to claim 10, further comprising a shield member which shields said frame from other spaces.

12. An exposure optical system according to claim 10, further comprising a gas supply device which supplies specific gas in the chambers partitioned by said partition member.

13. An exposure optical system according to claim 10, further comprising an illumination optical system which illuminates light onto a mask on which a pattern is formed.

14. An exposure optical system according to claim 10, further comprising a projection optical system which projects a pattern image of a mask illuminated by an illumination optical system onto a substrate.

15. An exposure optical system according to claim 12, wherein the specific gas supplied from said gas supply device is inert gas having absorbing property less than that of oxygen with respect to a wavelength area of the light illuminating a mask.

16. An exposure apparatus having the optical system according to claim 10.

17. An exposure apparatus having the optical system according to claim 15.

18. An exposure apparatus according to claim 17, wherein said path of the energy beam is a portion between an exposure light source and a mask illuminated by light from said exposure light source or a portion between said mask and a substrate on which a pattern image of said mask is projected or a portion between said exposure light source and said substrate.

19. A method for assembling an exposure optical system, comprising the steps of:
dividing a frame which contains a plurality of optical elements into a plurality of spaces; and
placing said optical elements in at least a part of said divided plural spaces.

20. A method according to claim 19, wherein a gas supply device which supplies specific gas into a first space among said spaces is connected to said frame.

21. A method according to claim 20, wherein said first space is provided with a sensor which detects oxygen density in said first space.

22. A method according to claim 21, wherein said first space is provided with a switching mechanism which switches between discharging of gas to a space adjacent to said first space and discharging gas out of said frame from said first space, on the basis of a detected result of said sensor.

23. A method according to claim 21, wherein said frame has an opening/closing lid which communicates said first space with atmosphere, and said first space is provided with a switching mechanism which switches between discharging of gas to a space adjacent to said first space and blocking of gas discharge from said first space to said adjacent space, in response to an opening/closing operation of said opening/closing lid.

24. A method according to claim 19, wherein said frame includes an illumination optical system constituted by the plurality of optical elements and adapted to illuminate light onto a mask on which a pattern is formed.

25. A method according to claim 24, wherein said frame further includes a projection optical system constituted by the plurality of optical elements and adapted to project a pattern image onto a substrate.

26. Method of assembling an exposure apparatus, for assembling an exposure apparatus by providing said exposure apparatus with the optical system assembled by the method according to claim 19.
